# EUROPÄISCHE PATENTSCHRIFT

(11) **EP 0 867 342 B1**
(45) Veröffentlichungstag und Bekanntmachung des Hinweises auf die Patenterteilung: **05.06.2002**
(21) Anmeldenummer: 98101801.3
(22) Anmeldetag: 03.02.1998
(51) Int. Cl.: B60R 16/02, B29C 45/14

(54) **Zentralelektrik für ein Kraftfahrzeug und Verfahren zu ihrer Herstellung**
Electrical distribution centre for a motor vehicle and method of producing the same
Centrale de distribution électrique pour véhicule automobile et procédé pour sa fabrication

(30) Priorität: 27.03.1997 DE 19713008
(43) Veröffentlichungstag der Anmeldung: 30.09.1998
(73) Patentinhaber: Neumann-Henneberg, Wolf, 78604 Rietheim-Weilheim (DE)
(72) Erfinder: Neumann-Henneberg, Wolf, 78604 Rietheim-Weilheim (DE)
(74) Vertreter: Späth, Dieter, Dipl.-Ing.

(56) Entgegenhaltungen:
- EP-A- 0 271 163
- EP-A- 0 387 845
- EP-A- 0 500 219
- EP-A- 0 590 644
- EP-A- 0 653 278
- DE-A- 4 101 368
- DE-B- 2 836 166
- DE-C- 3 608 752
- DE-C- 4 422 434

## Beschreibung

Die Erfindung betrifft ein Verfahren zum Herstellen einer Zentralelektik für ein Kraftfahrzeug gemäß dem Oberbegriff des Anspruchs 1. Des weiteren betrifft die Erfindung eine Zentralelektrik für ein Kraftfahrzeug nach dem Oberbegriff des Anspruchs 6.

Eine solche Zentralelektrik stellt eine zentrale Schnittstelle von Kraftfahrzeugelektriksystem dar. Sie weist Steckplätz für Relais und Sicherungen sowie Anschlußmöglichkeiten für mit elektrischen Kupplungsorganen versehene Kabelbäume auf. Aus Zuverlässigkeits- und Sicherheitsgründen muß eine solche Zentralelektrik sehr robust sein, um den hohen Belastungen beim Kraftfahrzeugbetrieb Stand zu halten.

Eine derartige Zentralelektrik ist bekannt aus der DE 36 08 752 C1. Die bekannte Zentralelektrik weist ein Kunststoffgehäuse mit einem Ober- und einem Unterteil auf, wobei sowohl in das Ober- als auch in das Unterteil aus mehreren Stegleitern bestehende Platinenebenen aus elektrisch leitendem Material, insbesondere aus Messing, mit Abstand voneinander in mehreren zueinander parallelen Ebenen eingesetzt sind. Durch den Abstand sind die Platinenebenen elektrisch voneinander isoliert. Bei der bekannten Zentralelektrik ist jedoch das Einsetzen der Platinenebenen in das Gehäuseober- und unterteil wegen der Anzahl der übereinander anzuordnenden Platinenebenen aufwendig. Ferner sind der Komplexität der elektrischen Leitungsführung Grenzen gesetzt, da zusätzliche Verbindungsleitungen weitere Platinenebenen erfordern, die mit wirtschaftlich vertretbarem Aufwand nicht mehr in das Gehäuse einsetzbar sind. Hinzu kommt, daß sich mit jeder zusätzlichen Platinenebene die Gefahr von unerwünschten elektrischen Kontakten zwischen benachbarten Platinenebenen, beispielsweise durch Lösen eines Stanzgitters von seinen Befestigungspunkten im Gehäuse oder durch Bruch von Befestigungselementen des Gehäuses, vergrößert, so daß eine ausreichend hohe Zuverlässigkeit der Zentralelektrik während der gesamten Gebrauchsdauer des Kraftfahrzeugs nicht mehr gewährleistet ist.

Der Erfindung liegt die Aufgabe zugrunde, eine Zentralelektrik für ein Kraftfahrzeug zu schaffen, die auch bei komplexer Leitungsführung einen einfachen Aufbau hat.

Diese Aufgabe wird erfindungsgemäß durch die Merkmale der Ansprüche 1 und 6 gelöst. Die erfindungsgemäße Zentralelektrik weist zwei oder mehr Stanzgitter mit gestanzten Stegleitem als elektrischen Verbindungsleitungen auf, die zunächst an Trennstellen miteinander verbunden sind. Jedes Stanzgitter wird mit einem Halterahmen aus Kunststoff umspritzt, so daß die Stegleiter durch den Halterahmen miteinander verbunden sind. Der Halterahmen weist Ausnehmungen an den Trennstellen des Stanzgitters auf, so daß die Trennstellen frei liegen. Nach dem Umspritzen mit dem Halterahmen werden die Stanzgitter an ihren Trennstellen in elektrisch voneinander isolierte Stegleiter getrennt. Das Trennen kann beispielsweise durch einen Stanzvorgang erfolgen, da die Trennstellen durch die Ausnehmungen des Halterahmens nach dem Umspritzen der Stanzgitter für ein Stanzwerkzeug zugänglich sind. Vorzugsweise erfolgt die Trennung mittels Ultraschalls, also durch Anregung des Stanzgitters zu hochfrequenten mechanischen Schwingungen an den Trennstellen, wodurch das Stanzgitter an den im Verhältnis zu den Stegleitern mit kleinem Querschnitt ausgebildeten Trennstellen zerstört wird. Um das Trennverhalten mit Ultraschall zu verbessern, sind die Trennstellen des Stanzgitters vorzugsweise gekerbt ausgebildet und zwar insbesondere durch Prägen von Kerben auf der Ober- und Unterseite des Stanzgitters und durch Kerben in der Ebene des Stanzgitters an Seiten der Trennstellen durch die Gestaltung des Stanzwerkzeugs, das zum Stanzen der Stanzgitter verwendet wird.

Zu biegende Abschnitte des Stanzgitters, also beispielsweise Zungen der Stegleiter, welche Anschlußkontakte oder Lötpins bilden, werden vorzugsweise nach dem Umspritzen des Stanzgitters mit dem Halterahmen gebogen. Zu diesem Zweck weist der Halterahmen Ausnehmungen auf, durch die die Biegestellen des Stanzgitters für ein Biegewerkzeug zugänglich sind und die einen zum Biegen erforderlichen Freiraum bieten. Des weiteren werden Abschnitte von Stegleitern als Stegleiterverbinder aus der Ebene des Stanzgitters so herausgebogen, daß Sie nach einem Zusammensetzen der Halterahmen an einem Stegleiter eines anderen Stanzgitters zur Anlage kommen. Die Halterahmen werden anschließend zusammengesetzt, wobei sie in ansich bekannter Weise beispielsweise durch nach Art einer Passung in komplementäre Löcher im einen Halterahmen eingreifende Zapfen eines anderen Halterahmens aneinander positioniert und beispielsweise durch. Rastnasen aneinander befestigt werden. Nach dem Zusammensetzen der Halterahmen werden die Stegleiterverbinder elektrisch leitend mit den dafür vorgesehenen Stegleitern jeweils eines anderen Stanzgitters verbunden. Die Verbindung kann durch Löten erfolgen, vorzugsweise erfolgt sich durch Ultraschallschweißung. Dadurch ist es auf einfache Weise möglich, Stegleiter aus verschiedenen Ebenen elektrisch leitend miteinander zu verbinden. Durch die Möglichkeit, Stegleiter von Stanzgittern in verschiedenen Ebenen elektrisch leitend miteinander zu verbinden, lassen sich elektrisch voneinander isolierte Stegleiter nahezu beliebig kreuzen, was komplexe Leitungsführungen mit einer geringen Anzahl von Stanzgittern ermöglicht. In vielen Fällen sind lediglich zwei Stanzgitter ausreichend.

Weitere Vorteile der erfindungsgemäßen Zentralelektrik ist deren Robustheit, da die elektrisch leitenden Stegleiter von den elektrisch isolierenden Halterahmen an vielen Stellen gehalten werden. Dadurch werden unbeabsichtigt elektrische Verbindungen, also Kurzschlüsse, dauerhaft auch bei den hohen, in einem Kraftfahrzeug auftretenden mechanischen Belastungen durch Vibration und Stoß vermieden. Die Zuverlässigkeit der erfindungsgemäßen Zentralelektrik ist dadurch hoch. Hinzu kommt die verringerte Anzahl von Stanzgittern, die für eine elektrische Leitungsführung erforderlich ist sowie der vereinfachte Zusammenbau durch einfaches Zusammensetzen der mit den Halterahmen umspritzten Stanzgitter.

Bei einer Weiterbildung der Erfindung weist ein oder weisen mehrere Stanzgitter in eine Richtung abstehend gebogene Lötpins auf die beispielsweise in einem Schwallbad mit Leiterbahnen einer kaschierten Leiterplatte verlötet werden. Auf diese Weise werden die Stegleiter der Stanzgitter mit komplett bestückten Leiterplatten, also mit elektronischen Schaltungen verschaltet, wodurch die erfindungsgemäße Zentralelektrik elektronische Funktionen erhält.

Um von einem Stanzgitter in Richtung eines anderen Stanzgitters abstehend gebogenen Abschnitten, also insbesondere den Anschlußkontakten und den Lötpins der Stegleiter, mechanischen Halt zu geben, weist der Halterahmen des anderen Stanzgitters bei Ausgestaltungen der Erfindung schlitzförmige Durchbrüche auf, durch die die abstehenden Abschnitte der Stegleiter des einen Stanzgitters hindurchragen.

Die abstehenden Abschnitte können bei einer Weiterbildung der Erfindung als Kontaktzunge mit einem Schlitz versehen sein und vorzugsweise beidseitig Rastnasen aufweisen, die den Halterahmen hintergreifen, durch den die Kontaktzunge hindurchragt. Auf diese Weise sind die Stegleiter eines Stanzgitters mit dem Halterahmen eines anderen Stanzgitters verrastet. Wird die Kontaktzunge beispielsweise durch Einstecken einer Sicherung, eines Messerkontaktes eines Relais oder eines Drahtes in ihren Schlitz aufgespreizt, ist die Verrastung gegen unbeabsichtigtes Lösen zusätzlich gesichert.

Um das Spreizverhalten der geschlitzten Kontakte zu verbessern, ist ihr Schlitz im Mittelbereich breiter als an den Enden, was die mechanische Belastbarkeit der Verrastung der Kontaktzunge mit dem Rahmen erhöht. Die Verrastung gibt der Kontaktzunge mechanischen Halt in Richtung senkrecht zum Stanzgitter, also gegen Zug oder Druck auf die Kontaktzunge.

Bei einer Ausgestaltung der Erfindung weisen eine oder mehrere Stegleiter eine Kontaktzunge mit einem Schlitz auf, in den ein Draht eingesetzt ist, der diese Kontaktzunge mit einer ebensolchen Kontaktzunge eines weiteren Stegleiters desselben oder eines anderen Stanzgitters elektrisch leitend verbindet. Diese Ausgestaltung der Erfindung ergibt zusätzliche Kreuzungsmöglichkeiten elektrisch voneinander isolierter Stegleiter, wodurch sich mit einfachen Mitteln noch komplexere Leitungsführungen verwirklichen lassen.

Bei einer Ausgestaltung der Erfindung ist an einem oder sind an mehreren Stegleitern ein Schraubanschluß beispielsweise in Form eines Gewindelochs zum Anbringen eines Kabelschuhs vorgesehen.

Die Erfindung wird nachfolgend anhand eines in der Zeichnung dargestellten Ausführungsbeispiels näher erläutert. Es zeigen:
- Figur 1: eine perspektivische Darstellung einer Zentralelektrik für ein Kraftfahrzeug gemäß der Erfindung;
- Figur 2: die Zentralelektrik aus Figur 1 in perspektivischer Darstellung von einer gegenüberliegenden Seite aus gesehen;
- Figur 3: eine vergrößerte Darstellung einer Einzelheit gemäß Pfeil III in Figur 1;
- Figur 4: eine Trennstelle zweier Stegleiter der erfindungsgemäßen Zentralelektrik; und
- Figur 5: eine vergrößerte Darstellung einer Kontaktzunge gemäß einer Ausgestaltung der Erfindung.

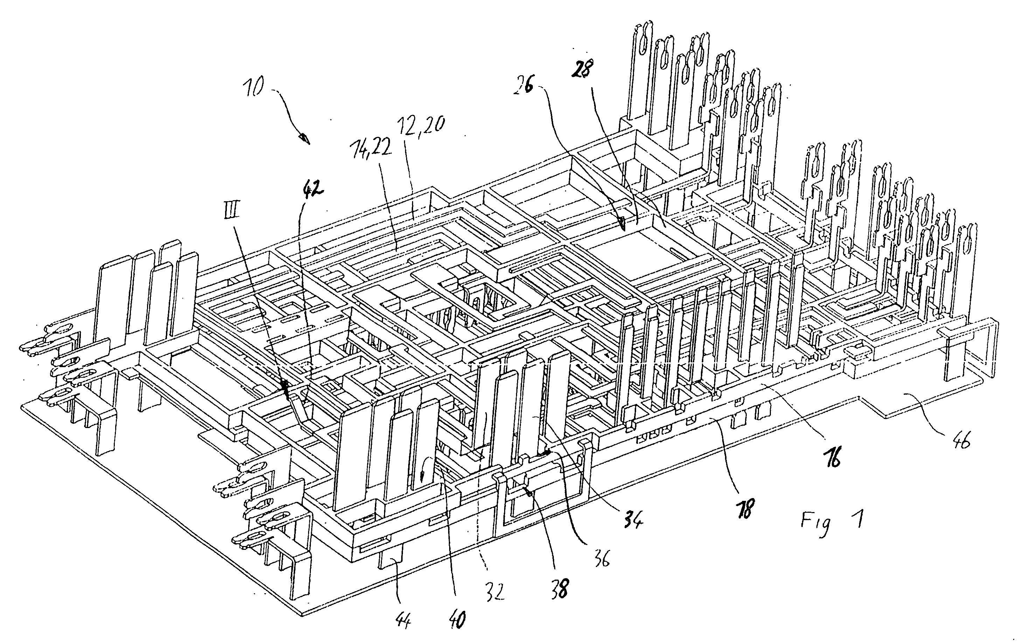

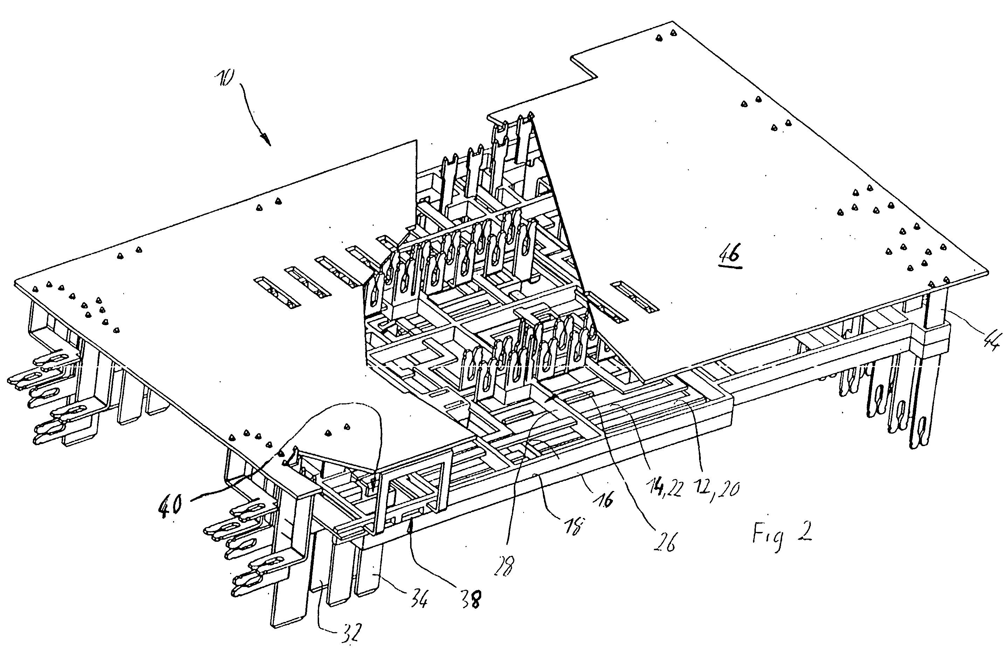

Die in Figuren 1 und 2 dargestellte, erfindungsgemäße Zentralelektrik 10 weist zwei Stanzgitter 12, 14 auf, die mit Abstand voneinander in zwei zueinander parallelen Ebenen angeordnet sind. Jedes der Stanzgitter 12, 14 ist mit einem eigenen Halterahmen 16, 18 aus Kunststoff umspritzt, die im wesentlichen deckungsgleich sind.

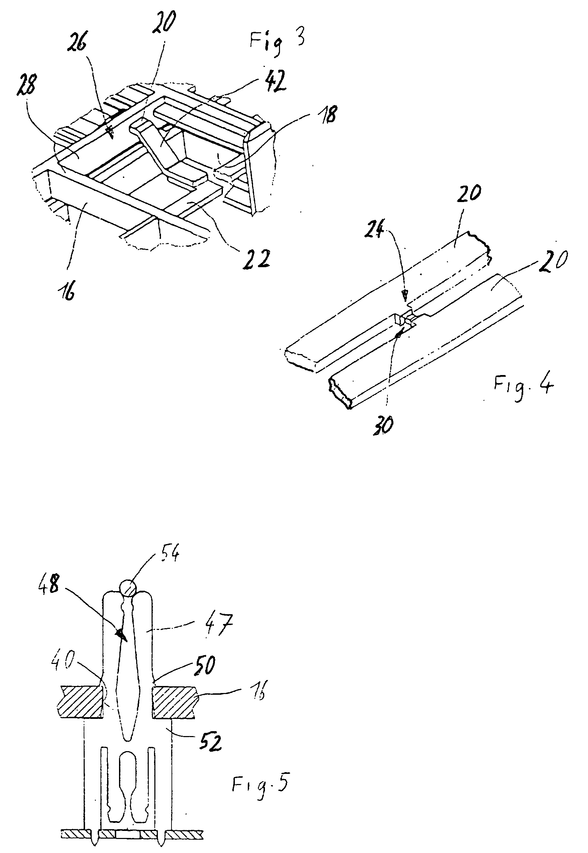

Die Stanzgitter 12, 14 sind aus einem ebenen Messingblech gestanzt. Durch das Stanzen sind Stegleiter 20, 22 gebildet, die bis zum Umspritzen mit den Halterahmen 16, 18 an Trennstellen 24 (Figur 4) mechanisch miteinander verbunden sind, um die Stegleiter 20, 22 eines Stanzgitters 12, 14 bis zum Umspritzen aneinander zu fixieren. Nach dem Umspritzen des Stanzgitters 12, 14 hält der Halterahmen 16, 18 die Stegleiter 20, 22 des Stanzgitters 12, 14 aneinander, so daß diese an den Trennstellen 24 voneinander getrennt werden können, um sie elektrisch voneinander zu isolieren.

Um das Stanzgitter 12, 22 an den Trennstellen 24 trennen zu können, sind die Trennstellen 24 für ein Trennwerkzeug frei zugänglich. Zu diesem Zweck weist der Halterahmen 16, 18 Ausnehmungen im Bereich der Trennstellen 24 auf, so daß die Trennstellen 24 frei liegen. Im dargestellten Ausführungsbeispiel werden die Ausnehmungen von Zwischenräumen 26, zwischen Stegen 28 des Halterahmens 16, 18 gebildet. Die Trennstellen 24 sind in Figuren 1 und 2 nicht sichtbar, da sie bereits entfernt worden sind.

Das Trennen kann beispielsweise durch Stanzen erfolgen. Im dargestellten Ausführungsbeispiel werden die Trennstellen 24 mit Ultraschall, d. h. durch Anregung des Stanzgitters 12, 14 im Bereich der Trennstellen 24 zu hochfrequenten, mechanischen Schwingungen zerstört. Um das Ultraschalltrennverhalten zu verbessern, weisen die Trennstellen 24 eine allseitige Kerbe 30 auf, d. h. die Trennstellen 24 sind von oben und unten durch Prägen sowie von beiden Seiten durch Stanzen gekerbt.

Ein vorgesehenes Biegen von Abschnitten der Stegleiter 20, 22, welche beispielsweise rechtwinklig abstehende Anschlußkontakte 32, 34 oder Lötpins 44 bilden, kann vor dem Umspritzen erfolgen. Vorzugsweise werden diese Abschnitte 32, 34 jedoch nach dem Umspritzen des Stanzgitters 12, 14 mit dem Halterahmen 16, 18 gebogen. Das Stanzgitter 12, 14 wird also in ebenem, noch nicht gebogenem Zustand umspritzt. Um das Biegen zu ermöglichen, weist der Halterahmen Ausnehmungen 36, 38 auf, in welchen die zu biegenden Abschnitte 32, 34, 44 nach dem Umspritzen einliegen und die einen zum Biegen der Abschnitte 32, 34, 44 erforderlichen Freiraum gewährleisten.

Nach dem Umspritzen der Stanzgitter 12, 14 mit den Halterahmen 16, 18, dem Trennen der Stanzgitter 12, 14 in elektrisch voneinander isolierte Stegleiter 20, 22 und dem Biegen der Anschlußkontakte 32, 34, und Lötpins 44 werden die im wesentlichen deckungsgleich ausgebildeten Halterahmen 16, 18 zusammengesetzt. Zur Positionierung weisen die Halterahmen 16, 18 an sich bekannte, in der Zeichnung nicht sichtbare Zapfen auf, die nach Art einer Passung in komplementäre Löcher des jeweils anderen Halterahmens 18, 16 eingeifen. Die Befestigung der Halterahmen 16, 18 aneinander erfolgt mittels an sich bekannter, nicht dargestellter Rastnasen, die beim Zusammendrücken der Halterahmen 16, 18 einrasten. Um den Anschlußkontakten 32, 34, Lötpins 44, und, sofern vorhanden, sonstigen abstehend gebogenen Abschnitten der Stegleiter 22 eines Stanzgitters 14, welche den Halterahmen 16 des anderen Stanzgitters 12 durchragen zusätzlichen mechanischen Halt zu geben, weist der durchragte Halterahmen 16 schlitzförmige Durchbrüche 40 auf, durch die die Anschlußkontakte 32, 34 und Lötpins 44 hindurchragen.

Zur elektrisch leitenden Verbindung zweier Stegleiter 20, 22 verschiedener Stanzgitter 12, 14 weist zumindest einer dieser Stegleiter 20 einen im dargestellten Ausführungsbeispiel gekröpft gebogenen Abschnitt auf, welcher als Stegleiterverbinder 42 so gebogen ist, daß er nach dem Zusammensetzen der Halterahmen 16, 18 an dem Stegleiter 22 des anderen Stanzgitters 14, mit dem er elektrisch leitend verbunden werden soll, anliegt (Figur 3). Das Biegen des Stegleiterverbinders 42 kann wie das Biegen der Anschlußkontakte 32, 34 und Lötpins 44 vor oder nach dem Umspritzen der Stanzgitter 12, 14 mit den Halterahmen 16, 18 erfolgen. Die Halterahmen 16, 18 weisen zu diesem Zweck auch im Bereich der Stegleiterverbinder 42 Ausnehmungen in Form von Zwischenräumen 26 zwischen Stegen 28 des Halterahmens 16 auf, durch die die Stegleiterverbinder 42 für ein Biegewerkzeug frei zugänglich sind. Das Verbinden der Stegleiter 20, 22 miteinander erfolgt durch Ultraschallschweißung.

Die Stanzgitter 12, 14 der in der Zeichnung dargestellten, erfindungsgemäßen Zentralelektrik 10, weisen Lötpins 44 auf, die wie die Anschlußkontakte 32, 34 rechtwinklig von einer Seite der Zentralelektrik 10 abstehend gebogen sind. Diese sind in an sich bekannter Weise in einem Schwallbad mit Leiterbahnen einer kaschierten Leiterplatte 46 verlötet. Dies ergibt zum einen zusätzliche Möglichkeiten der elekttrisch leitenden Verbindung von Stegleitern 20, 22 eines oder verschiedener Stanzgitter 12, 14 miteinander. Zum anderen besteht die Möglichkeit, die Stegleitr 20, 22 mit elektronischen Bauelementen, mit welchen die Leiterplatte 46 bestückt ist, zu verschalten, wodurch die Zentralelektrik 10 elektronische Funktionen erhält. Von letzterer Möglichkeit ist im dargestellten Ausführungsbeispiel kein Gebrauch gemacht. Da die Leiterbahnen der Leiterplatte 46 mit einer Schutzschicht abgedeckt sind, sind sie in der Zeichnung nicht sichtbar.

Wie in Figur 5 dargestellt, können Anschlußkontakte 47, welche durch einen schlitzförmigen Durchbruch 40 eines Halterahmens 16 hindurchragen, einen einseitig offenen Schlitz 48 und seitliche Rastrasen 50 aufweisen. Die Rastnasen 50 übergreifen den Halterahmen 16 und halten dadurch den Anschlußkontakt 47 im Halterahmen 16. Die Rastnasen 50 wirken zusammen mit Schultern 52, welche auf einer gegenüberliegenden Seite des Halterahmens 16 anliegen. Der Anschlußkontakt 47 wird dadurch gegen Zug und Druck, wie er beim Stecken und Abziehen eines nicht dargestellten Gegenkontaktes auftritt, am Halterahmen 16 gesichert. Der Schlitz 48 ermöglicht ein seitliches Federn der Rastnasen 50 beim Durchstecken des Anschlußkontaktes 47 durch den schlitzförmigen Durchbruck 40 des Halterahmens 16.

Der Schlitz 48 weist eine breiteste Stelle in Höhe der Rastnasen 50 auf, zu seinen Enden hin wird der Schlitz 48 schmaler. Dadurch wird bewirkt, daß eine Aufspreizkraft im Bereich der Rastnasen 50 am größten ist. Durch Einstecken eines Drahtes 54, der in Figur 5 an einer Mündung des Schlitzes 48 dargestellt ist, in den Schlitz 48 hinein, wird der Anschlußkontakt 47 zusätzlich aufgespreizt und aufgespreizt gehalten, wodurch die Fixierung des Anschlußkontaktes 47 mit seinen Rastnasen 50 am Halterahmen 16 gesichert ist. Durch den Draht 54 kann der Anschlußkontakt 47 mit einem weiteren, nicht dargestellten, ebensolchen Anschlußkontakt 47 elektrisch leitend verbunden werden. Dies ergibt eine weitere einfache Möglichkeit, Stegleiter 20, 22 insbesondere eines Stanzgitters 12, 14, aber auch verschiedener Stanzgitter 12, 14 elektrisch leitend miteinander zu verbinden. Das Aufspreizen des Anschlußkontaktes 47 kann anstelle mit dem Draht 54 beispielsweise auch durch Einstecken eines Messerkontaktes eines Relais oder eines Sicherungselementes in den Schlitz 48 des Anschlußkontaktes 47 erfolgen (nicht dargestellt).

Die dargestellte Zentralelektrik 10 ist zum Einsetzen in ein nicht dargestelltes Gehäuse vorgesehen, welches in an sich bekannter Weise Steckplätze für Relais, Sicherungen, Kupplungsorgane von Einzelkabelbäumen und dgl. aufweist, die diesen Steckelementen mechanischen Halt geben und in die die Anschlußkontakte 32, 34 der Zentralelektrik 10 hineinragen.

## Patentansprüche

1. Verfahren zum Herstellen einer Zentralelektrik (10) für ein Kraftfahrzeug mit in wenigstens zwei beabstandeten, im wesentlichen zueinander parallelen Ebenen angeordneten Stegleitern (20, 22) wobei vorgesehene Abschnitte wie Anschlußkontakte (32, 34) oder Lötpins (44) der Stegleiter (20, 22) von den Ebenen abstehend gebogen werden, **dadurch gekennzeichnet, daß** zwei elektrisch leitende Stanzgitter (12, 14) unabhängig voneinander mit je einem Halterahmen (16, 18) aus Kunststoff umspritzt werden, wobei die Stanzgitter (12, 14) Trennstellen (24) aufweisen, an denen sie in elektrisch voneinander isolierte Stegleiter (20, 22) trennbar sind, und wobei die Halterahmen (16, 18) Ausnehmungen (26) an den Trennstellen (24) der Stanzgitter (12, 14) aufweisen, so daß die Trennstellen (24) frei liegen, daß die Stanzgitter (12, 14) nach dem Umspritzen an ihren Trennstellen (24) in die Stegleiter (20, 22) getrennt werden, daß die die Stegleiter (20, 22) haltenden Halterahmen (16, 18) zusammengesetzt werden, und daß zumindest zwei Stegleiter (20, 22) der Stanzgitter (12, 14) der zwei Ebenen, von denen ein Stegleiter (20) einen als Stegleiterverbinder (42) zum Stegleiter (22) des anderen Stanzgitters (14) gebogenen Abschnitt aufweist, elektrisch leitend miteinander verbunden werden.

2. Verfahren nach Anspruch 1, **dadurch gekennzeichnet, daß** die Stanzgitter (12, 14) nach dem Umspritzen gebogen werden.

3. Verfahren nach Anspruch 1 oder 2, **dadurch gekennzeichnet, daß** das Trennen der Stanzgitter (12, 14) an den Trennstellen (24) durch Ultraschall erfolgt.

4. Verfahren nach Anspruch 1, **dadurch gekennzeichnet, daß** die elektrisch leitende Verbindung der Stegleiter (20, 22) zweier Stanzgitter (12, 14) durch Ultraschallschweißen erfolgt.

5. Verfahren nach einem der Ansprüche 1 bis 4, **dadurch gekennzeichnet, daß** abstehend gebogene Lötpins (44) der Stegleiter (20, 22) der Stanzgitter (12, 14) mit Leiterbahnen einer kaschierten Leiterplatte (46) verlötet werden.

6. Zentralelektrik (10) für ein Kraftfahrzeug mit wenigstens zwei mit Abstand in zwei im wesentlichen zueinander parallen Ebenen angeordneten Stegleitern (20, 22), wobei vorgesehene Abschnitte, wie Anschlußkontakte (32, 34) oder Lötpins (44) der Stegleiter (20, 22) von den Ebenen abstehend gebogen sind, **dadurch gekennzeichnet, daß** elektrisch leitende Stanzgitter (12, 14) jeder Ebene mit einem Halterahmen (16, 18) aus Kunststoff umspritzt sind, daß die Stanzgitter (12, 14) Trennstellen (24) aufweisen, an denen sie in elektrisch voneinander isolierte Stegleiter (20, 22) getrennt sind, daß die Halterahmen (16, 18) Ausnehmungen (26, 36, 38) an den Trennstellen (24) und an Biegestellen der Stegleiter (20, 22) der Stanzgitter (12, 14) aufweisen, so daß die Trennstellen (24) und die Biegestellen zugänglich sind, daß die die Stegleiter (20, 22) haltenden Halterahmen (16, 28) zusammengesetzt sind, und daß zumindest ein Abschnitt eines Stegleiters (20) des Stanzgitters (12) einer Ebene als Stegleiterverbinder (42) zu einem Stegleiter (22) eines Stanzgitters (14) der anderen Ebene gebogen und mit diesem elektrisch leitend verbunden ist.

7. Zentralelektrik nach Anspruch 6, **dadurch gekennzeichnet, daß** mindestens ein Halterahmen (16, 18) einen schlitzförmigen Durchbruch (40) aufweist, durch den ein von einem Stegleiter (20, 22) eines Stanzgitters (12, 14) eines anderen Halterahmens (18, 16) abstehend gebogener Abschnitt (32, 34) hindurchragt.

8. Zentralelektrik nach Anspruch 6 oder 7, **dadurch gekennzeichnet, daß** die Halterahmen (16, 18) im wesentlichen deckungsgleich sind.

9. Zentralelektrik nach Anspruch 6, **dadurch gekennzeichnet, daß** die Trennstellen (24) der Stanzgitter (12, 14) gekerbt sind.

10. Zentralelektrik nach einem der Ansprüche 6 bis 8, **dadurch gekennzeichnet, daß** mindestens ein Stegleiter (12, 14) einen als geschlitzte Kontaktzunge (47) ausgebildeten, abstehend umgebogenen Abschnitt aufweist, wobei die Kontaktzunge (47) durch den schlitzförmigen Durchbruch (40) des Halterahmens (16) ragt, daß die Kontaktzunge (47) mindestens eine Rastnase (50) aufweist, die den Halterahmen (16) hintergreift, und daß der Schlitz (48) der Kontaktzunge (47) bis in den Bereich des Halterahmens (16) reicht.

11. Zentralelektrik nach Anspruch 10, **dadurch gekennzeichnet, daß** der Schlitz (48) der Kontaktzunge (47) in seinem Mittelbereich breiter als an seinen Enden ist.

12. Zentralelektrik nach Anspruch 6, **dadurch gekennzeichnet, daß** in den Schlitz (48) der Kontaktzunge (47) ein Draht (54) eingelegt ist, der diese Kontaktzunge (47) elektrisch leitend mit einer zweiten, ebensolchen Kontaktzunge (47) verbindet.

13. Zentralelektrik nach Anspruch 6, **dadurch gekennzeichnet, daß** mindestens ein Stegleiter (20, 22) einen Lötpin (44) aufweist, der mit einer Leiterbahn einer kaschierten Leiterplatte (46) verlötet ist.

14. Zentralelektrik nach Anspruch 6, **dadurch gekennzeichnet, daß** mindestens ein Stegleiter (20, 22) einen Schraubanschluß zum Anbringen eines Kabelschuhs aufweist.

## Claims

1. A method of manufacturing a central electric system (10) for a motor vehicle with web conductors (20, 22) spaced apart from each other and arranged in at least two planes that are essentially parallel to one another, wherein intended sections such as terminal contacts (32, 34) or soldering pins (44) of the web conductors (20, 22) are bent so they project away from the tiers, **characterized in that** two electrically conducting pressed screens (12, 14) are each extrusion coated independently of one another with a holding frame (16, 18) made of plastic, where pressed screens (12, 14) have separation points (24) at which they can be separated into electrically insulated web conductors (20, 22), and where the holding frames (16, 18) have recesses (26) at the separation points (24) of the pressed screens (12, 14), so that the separation points (24) are freely exposed, the pressed screens (12, 14), after being extrusion coated, are separated into their web conductors (20, 22) at their separation points (24); the holding frames (16, 18) which hold the web conductors (20, 22) are assembled; and at least two web conductors (20, 22) of the pressed screens (12, 14) of the two tiers are electrically connected to one another, where one web conductor (20) has a bent section as the web conductor connector (42) to the web conductor (22) of the other pressed screen (14).

2. The method according to claim 1, **characterized in that** the pressed screens (12, 14) are bent after being extrusion coated.

3. The method according to claim 1 or 2, **characterized in that** the pressed screens (12, 14) are separated at the separation points (24) by ultrasound.

4. The method according to claim 1, **characterized in that** the electric connection of web conductors (20, 22) of two pressed screens (12, 14) is accomplished by ultrasonic welding.

5. The method according to one of claims 1 through 4, **characterized in that** soldering pins (44) bent to project away from the web conductors (20, 22) of the pressed screens (12, 14) are soldered to printed conductors of a laminated circuit board (46).

6. A central electric system (10) for a motor vehicle with at least two web conductors (20, 22) arranged with a distance between them in essentially parallel planes, wherein intended sections such as terminal contacts (32, 34) or soldering pins (44) of the web conductors (20, 22) are bent so they project away from the tiers, **characterized in that** the electrically conducting pressed screen (12, 14) of each plane is extrusion coated with a holding frame (16, 18) made of plastic; the pressed screens (12, 14) have separation points (24) at which they are separated into electrically insulated web conductors (20, 22); the holding frames (16, 18) have recesses (26, 36, 38) at the separation points (24) and at bending points on the web conductors (20, 22) of the pressed screens (12, 14), so that the holding frames (16, 28) [sic; (16, 18)] holding the web conductors (20, 22) are assembled, and at least one section of a web conductor (20) of the pressed screen (12) of a tier is bent to form the web conductor connector (42) to a web conductor (22) of a pressed screen (14) of the other tier and is electrically connected to it.

7. The central electric system according to claim 6, **characterized in that** at least one holding frame (16, 18) has a slotted passage (40) through which passes a section (32, 34) which is bent so that it projects away from a web conductor (20, 22) of a pressed screen (12, 14) of another holding frame (18, 16).

8. The central electric system according to claim 6 or 7, **characterized in that** the holding frames (16, 18) are essentially identical.

9. The central electric system according to claim 6, **characterized in that** the separation points (24) of the pressed screens (12, 14) are notched.

10. The central electric system according to one of claims 6 through 8, **characterized in that** at least one web conductor (12, 14) has a bent section projecting outward and designed as a slotted contact tongue (47), where the contact tongue (47) passes through the slotted passage (40) of the holding frame (16); the contact tongue (47) has at least one catch lug (50) which engages behind the holding frame (16), and the slot (48) of the contact tongue (47) extends into the area of the holding frame (16).

11. The central electric system according to claim 10, **characterized in that** the slot (48) of the contact tongue (47) is wider in its middle area than at its end.

12. The central electric system according to claim 6, **characterized in that** a wire (54) is inserted into the slot (48) of the contact tongue (47) and establishes an electric connection between this contact tongue (47) and a second identical contact tongue (47).

13. The central electric system according to claim 6, **characterized in that** at least one web conductor (20, 22) has a soldering pin (44) which is soldered to a printed conductor of a laminated circuit board (46).

14. The central electric system according to claim 6, **characterized in that** at least one web conductor (20, 22) has a screw connection for applying a cable lug.

## Revendications

1. Procédé de fabrication d'une centrale de distribution électrique (10) pour un véhicule automobile avec au moins deux conducteurs transversaux (20, 22) disposés écartés dans des plans approximativement parallèles l'un à l'autre, des sections prévues comme des contacts de raccordement (32, 34) ou broches de brasage (44) des conducteurs transversaux (20, 22) étant cintrées avec écartement par rapport aux plans, **caractérisé en ce que** deux grilles découpées (12, 14) conductrices d'électricité sont incrustées par injection indépendamment l'une de l'autre respectivement dans un cadre support (16, 18) en plastique, les grilles découpées (12, 14) présentant des points de séparation (24), auxquels elles sont séparables en conducteurs transversaux (20, 22) isolés l'un de l'autre au point de vue électrique, et les cadres supports (16, 18) présentant des évidements (26) aux points de séparation (24) des grilles découpées (12, 14), de telle sorte que les points de séparation (24) sont dégagés, que les grilles découpées (12, 14) sont séparées après l'incrustation par injection à leurs points de séparation (24) en conducteurs transversaux (20, 22), que les cadres supports (16, 18) maintenant les conducteurs transversaux (20,22) sont assemblés, et qu'au moins deux conducteurs transversaux (20, 22) des grilles découpées (12, 14) des deux plans, dont un conducteur transversal (20) présente en tant que connecteur de conducteur transversal (42) une section cintrée vers le conducteur transversal (22) de l'autre grille découpée (14), sont reliés l'un à l'autre avec conduction électrique.

2. Procédé selon la revendication 1, **caractérisé en ce que** les grilles découpées (12, 14) sont cintrées après l'incrustation par injection.

3. Procédé selon la revendication 1 ou 2, **caractérisé en ce que** la séparation des grilles découpées (12, 14) est réalisée aux points de séparation (24) par ultrasons.

4. Procédé selon la revendication 1, **caractérisé en ce que** la liaison à conduction électrique des conducteurs transversaux (20, 22) des deux grilles découpées (12, 14) est réalisée par soudure à ultrasons.

5. Procédé selon une des revendications 1 à 4, **caractérisé en ce que** les broches de brasage (44) cintrées avec écartement des conducteurs transversaux (20, 22) des grilles découpées (12, 14) sont brasées avec les pistes conductrices d'un circuit imprimé doublé (46).

6. Centrale de distribution électrique (10) pour véhicule automobile avec au moins deux conducteurs transversaux (20, 22) disposés avec écartement dans deux plans approximativement parallèles l'un à l'autre, des sections prévues comme des contacts de raccordement (32, 34) ou des broches de brasage (44) des conducteurs transversaux (20, 22) étant cintrées en s'écartant des plans, **caractérisée en ce que** des grilles découpées (12, 14) conductrices d'électricité de chaque plan sont incrustées par injection dans un cadre support (16, 18) en matière plastique, que les grilles découpées (12, 14) présentent des points de séparation (24) auxquels elles sont séparées en conducteurs transversaux (20, 22) isolés les uns des autres du point de vue électrique, que les cadres supports (16, 18) présentent des évidements (26, 36, 38) aux points de séparation (24) et aux points de cintrage des conducteurs transversaux (20, 22) des grilles découpées (12, 14), de telle sorte que les points de séparation (24) et les points de cintrage sont accessibles, que les cadres supports (16, 28) maintenant les conducteurs transversaux (20, 22) sont assemblés et qu'au moins une section d'un conducteur transversal (20) de la grille découpée (13) d'un plan est cintrée en tant que connecteur de conducteur transversal (42) vers un conducteur transversal (22) d'une grille découpée (14) de l'autre plan et est reliée avec celui-ci avec conduction électrique.

7. Centrale de distribution électrique selon la revendication 6, **caractérisée en ce qu'**au moins un cadre support (16, 18) présente une percée (40) en forme de fente, à travers laquelle dépasse une section (32, 34) centrée avec écartement par rapport à un conducteur transversal (20, 22) d'une grille découpée (12, 14) d'un autre cadre support (18, 16).

8. Centrale de distribution électrique selon la revendication 6 ou 7, **caractérisée en ce que** les cadres supports (16, 18) sont globalement de recouvrement identique.

9. Centrale de distribution électrique selon la revendication 6, **caractérisée en ce que** les points de séparation (24) des grilles découpées (12, 14) sont entaillés.

10. Centrale de distribution électrique selon une des revendications 6 à 8, **caractérisée en ce qu'**au moins un conducteur transversal (12, 14) présente une section cintrée avec écartement formée en tant que languette de contact fendue (47), la languette de contact (47) dépassant à travers une percée (40) en forme de fente du cadre support (16), que la languette de contact (47) présente au moins un bec d'enclenchement (50), qui agrippe le cadre support (16) par l'arrière, et que la fente (48) de la languette de contact (47) va jusqu'à la zone du cadre support (16).

11. Centrale de distribution électrique selon la revendication 10, **caractérisée en ce que** la fente (48) de la languette de contact (47) est plus large dans sa zone centrale qu'à ses extrémités.

12. Centrale de distribution électrique selon la revendication 6, **caractérisée en ce qu'**un fil électrique (54) qui relie cette languette de contact (47) avec conduction électrique à une deuxième languette de contact similaire (47) est inséré dans la fente (48) de la languette de contact (47).

13. Centrale de distribution électrique selon la revendication 6, **caractérisée en ce qu'**au moins un conducteur transversal (20, 22) présente une broche de brasage (44) qui est brasée avec une piste conductrice d'un circuit imprimé doublé (46).

14. Centrale de distribution électrique selon la revendication 6, **caractérisée en ce qu'**au moins un conducteur transversal (20, 22) présente un raccordement à vis pour la mise en place d'un raccord de câble.
